# EUROPEAN PATENT APPLICATION

(11) **EP 4 572 565 A1**
(43) Date of publication of application: **18.06.2025**
(21) Application number: 24210887.6
(22) Date of filing: 05.11.2024
(51) Int. Cl.: H10D 84/01, H10D 30/01, H10D 30/00, H10D 84/03, H10D 84/83, H10D 84/85

(54) **CONDUCTIVE INTERCONNECT STRUCTURE WITHIN GATE CUT**

(30) Priority: 15.12.2023 US 202318542162
(71) Applicant: INTEL Corporation, Santa Clara, CA 95054 (US)
(72) Inventor: JUN, Hwichan, Portland, 97229 (US); GUHA Neogi, Tuhin, Sherwood, 97140 (US); BOUCHE, Guillaume, Portland, 97211 (US)
(74) Representative: Goddar, Heinz J.

(57) **Abstract**

Techniques are provided herein to form semiconductor devices that include an interconnect structure, or a portion thereof, within a gate cut. A semiconductor device includes a gate structure around or otherwise on a semiconductor region. The gate structure may be interrupted, for example, between two transistors with a gate cut that extends through an entire thickness of the gate structure and includes dielectric material to electrically isolate the portions of the gate structure on either side of the gate cut. A top surface of dielectric fill material of the gate cut is recessed or otherwise below a top surface of the gate structure, and a conductive structure is sits on the dielectric fill within the gate cut. The conductive structure may, for example, contact another conductive structure above it or a conductive contact between the conductive structure and a metal line within an interconnect region above the semiconductor device.

## Description

### BACKGROUND

As integrated circuits continue to scale downward in size, a number of challenges arise. For instance, reducing the size of memory and logic cells is becoming increasingly more difficult, as is reducing device spacing at the device layer and in the interconnect region. As transistors are packed more densely, the formation of certain interconnect structures becomes challenging. Accordingly, there remain a number of non-trivial challenges with respect to forming semiconductor devices.

### BRIEF DESCRIPTION OF THE DRAWINGS

Figures 1A and 1B are cross-sectional and plan views, respectively, of some semiconductor devices that illustrate a conductive interconnect structure within a gate cut, in accordance with an embodiment of the present disclosure.
Figures 2A - 2L are cross-sectional views that illustrate various stages in an example process for forming semiconductor devices that have a conductive interconnect structure within a gate cut, in accordance with some embodiments of the present disclosure.
Figure 3A - 3C are plan views that illustrate various stages in the example process for forming semiconductor devices that have a conductive interconnect structure within a gate cut, in accordance with some embodiments of the present disclosure.
Figure 4 illustrates a cross-sectional view of a chip package containing one or more semiconductor dies, in accordance with some embodiments of the present disclosure.
Figure 5 is a flowchart of a fabrication process for semiconductor devices having a conductive interconnect structure within a gate cut, in accordance with an embodiment of the present disclosure.
Figure 6 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices that include an interconnect structure, or an extension of a interconnect structure, within a gate cut. The techniques can be used in any number of integrated circuit applications and are particularly useful with respect to device layer transistors, such as finFETs, gate-all-around transistors (e.g., ribbonFETs and nanowire FETs), or forksheet transistors. In an example, a semiconductor device includes a gate structure around or otherwise on a semiconductor region. The semiconductor region can be, for example, a fin of semiconductor material that extends from a source region to a drain region, or one or more nanowires or nanoribbons or nanosheets of semiconductor material that extend from a source region to a drain region. The gate structure includes a gate dielectric (e.g., high-k gate dielectric material) and a gate electrode (e.g., conductive material such as workfunction material and/or gate fill metal). The gate structure may be interrupted, for example, between two transistors with a gate cut that extends through an entire thickness of the gate structure and includes dielectric material to electrically isolate the portions of the gate structure on either side of the gate cut. In an example, a conductive structure is formed within a central portion of the gate cut and on top of a dielectric fill within the gate cut. The conductive structure may contact a higher conductive structure or a conductive contact between the conductive structure and a metal line within the interconnect region. The presence of the conductive structure conductively coupled to a metal line increases the surface area for current to flow through the metal line and can decrease the overall resistance of the metal line. Leveraging the space within a gate cut to provide additional area for current flow allows for the metal lines themselves to remain relatively narrow, which saves space in the interconnect region. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. Metal interconnects are used in integrated circuits to route signal and power between the various semiconductor devices and also to any number of input/output (I/O) terminals. As devices scale ever smaller, the number of interconnects needed increases, yet the available space in the interconnect region remains the same. Accordingly, many metal lines are made narrower in order to fit them within the available space. However, this can have drawbacks with regards to the overall resistance of the lines, as narrower lines decreases the surface area through which the current flows along the given metal line.

Thus, and in accordance with an embodiment of the present disclosure, techniques are provided herein to increase the area of one or more interconnect metal lines by using conductive structures within gate cuts. As noted above, the gate cuts are dielectric structures that cut through the transistor gate structures and perpendicular to the gate trenches. The gate cuts may run along cell boundaries beneath metal lines in the first interconnect metal layer (sometimes referred to as metal 0). According to some embodiments, a gate cut includes a dielectric layer (or liner) along outer edges of the gate cut and a dielectric fill on the dielectric layer. The dielectric layer can include a high-k material (e.g., material with a dielectric constant greater than or equal to 6.5). The dielectric layer may include, for example, a conformal deposition of silicon nitride or other suitable relatively high-k material. Since the outer layer is along the edges of the gate cut, it may contact the gate electrode on either side of the gate cut. According to some embodiments, the dielectric fill includes a low-k material (e.g., material with a dielectric constant less than or equal to 4.5). Silicon dioxide or flowable silicon dioxide or porous silicon dioxide may be used for the dielectric fill, to provide a few examples.

According to some embodiments, the dielectric fill within the gate cut is recessed below a top surface of the adjacent gate structure and a conductive structure is present within the gate cut and on a top surface of the dielectric fill. The conductive structure may be separated from the adjacent gate structures by the dielectric layer/liner along the outer edge of the gate cut. According to some embodiments, the conductive structure may run lengthwise along an entire length of the gate cut, or may run only along a portion of the entire length of the gate cut. One or more additional conductive structures may be arranged on the conductive structure to connect the conductive structure to a first metal line within the interconnect region above the semiconductor devices. In this way, the cross-section surface area of the metal line is increased through the addition of the conductive structure within the gate cut.

According to an embodiment, an integrated circuit includes a semiconductor device having a semiconductor region extending in a first direction from a source or drain region, and a gate structure extending in a second direction over the semiconductor region, and a gate cut adjacent to the semiconductor device and extending along the first direction and along a third direction through an entire height of the gate structure. The gate cut includes a dielectric layer along edges of the gate cut and a dielectric fill on the dielectric layer. A top surface of the dielectric fill is below a top surface of the gate structure. The integrated circuit also includes a conductive structure on a top surface of the dielectric fill such that sidewalls of the conductive structure contact the dielectric layer.

According to an embodiment, an integrated circuit includes a semiconductor device having a semiconductor region extending in a first direction from a source or drain region, and a gate structure extending in a second direction over the semiconductor region, and a gate cut adjacent to the semiconductor device and extending along the first direction and along a third direction through an entire height of the gate structure. The gate cut includes a dielectric layer along edges of the gate cut and a dielectric fill on the dielectric layer. A top surface of the dielectric fill is below a top surface of the gate structure. The integrated circuit also includes a conductive structure that includes a first conductive portion on the dielectric fill and having sidewalls that contact the dielectric layer, a second conductive portion on the first conductive portion, and a third conductive portion on the second conductive portion. The third conductive portion has a greater width along the second direction than both of the first conductive portion and the second conductive portion.

According to another embodiment, a method of forming an integrated circuit includes forming one or more fins comprising semiconductor material, the one or more fins extending above a substrate and each extending parallel to one another in a first direction; forming a gate electrode extending over the semiconductor material in a second direction different from the first direction; forming a recess extending across the gate electrode in the first direction and extending in a third direction through an entire height of the gate electrode; forming a dielectric layer within the recess; forming a dielectric fill within a remaining volume of the recess and on the dielectric layer; recessing a top surface of the dielectric fill to form a partial recess; and forming a conductive structure on the top surface of the dielectric fill within the partial recess.

The techniques can be used with any type of non-planar transistors, including finFETs (sometimes called tri-gate transistors), nanowire and nanoribbon transistors (sometimes called gate-all-around transistors), or forksheet transistors, to name a few examples. The source and drain regions can be, for example, doped portions of a given fin or substrate, or epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a conductive structure within a portion of a gate cut and running along at least a portion of the length of the gate cut. Such a conductive structure may be part of a larger conductive structure that includes one or more metal lines in the interconnect region. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

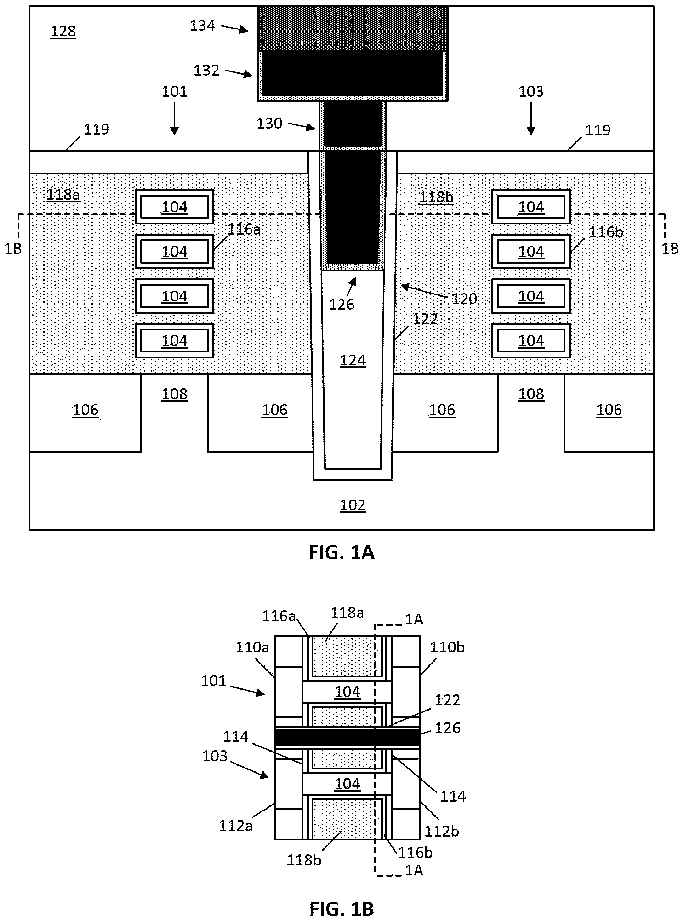

Figure 1A is a cross-sectional view taken across two example semiconductor devices 101 and 103, according to an embodiment of the present disclosure. Figure 1B is a top-down cross-section view of the adjacent semiconductor devices 101 and 103 taken across the dashed line 1B-1B depicted in Figure 1A, and Figure 1A illustrates the cross-section taken across the dashed line 1A-1A depicted in Figure 1B. It should be noted that some of the material layers (such as dielectric cap 119) are not visible in the top-down view of Figure 1B, given the location of the depicted cross-section. Each of semiconductor devices 101 and 103 may be non-planar metal oxide semiconductor (MOS) transistors, such as tri-gate (e.g., finFET), gate-all-around (GAA) transistors, or forksheet transistors, although other transistor topologies and types could also benefit from the gate cut techniques and structures provided herein. The illustrated example embodiments herein use the GAA structure. Semiconductor devices 101 and 103 represent a portion of an integrated circuit that may contain any number of similar semiconductor devices.

As can be seen, semiconductor devices 101 and 103 are formed on a substrate 102. Any number of semiconductor devices can be formed on substrate 102, but two are used here as an example. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some example embodiments, a lower portion of (or all of) substrate 102 is removed and replaced with one or more backside interconnect layers to form backside signal and power routing.

Each of semiconductor devices 101 and 103 includes one or more nanoribbons 104 that extend parallel to one another along a direction between a source region and a drain region (e.g., a first direction into and out of the page in the cross-section view of Figure 1A). Nanoribbons 104 are one example of semiconductor regions or semiconductor bodies that extend between source and drain regions. The term nanoribbon may also encompass other similar shapes such as nanowires or nanosheets. The semiconductor material of nanoribbons 104 may be formed from substrate 102. In some embodiments, semiconductor devices 101 and 103 may each include semiconductor regions in the shape of fins that can be, for example, native to substrate 102 (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of the illustrated nanoribbons 104 during a gate forming process where one type of the alternating layers is selectively etched away so as to liberate the other type of alternating layers within the channel region, so that a gate-all-around (GAA) process can then be carried out. Again, the alternating layers can be blanket deposited and then etched into fins or deposited into fin-shaped trenches, according to some examples.

As can further be seen, adjacent semiconductor devices are separated by a dielectric fill 106 that may include silicon dioxide. Dielectric fill 106 provides shallow trench isolation (STI) between any adjacent semiconductor devices, and adjacent subfin regions 108. Dielectric fill 106 can be any suitable dielectric material, such as silicon dioxide, aluminum oxide, or silicon oxycarbonitride.

Semiconductor devices 101 and 103 each include a subfin region 108, in this example. According to some embodiments, subfin region 108 comprises the same semiconductor material as substrate 102 and is adjacent to dielectric fill 106. According to some embodiments, nanoribbons 104 (or other semiconductor bodies) extend between source or drain regions in the first direction to provide an active region for a transistor (e.g., the semiconductor region beneath the gate). The source and drain regions are not shown in the cross-section of Figure 1A, but are seen in the top-down view of Figure 1B where nanoribbons 104 of semiconductor device 101 extend between a first source or drain region 110a and a second source or drain region 110b (similarly, the nanoribbons 104 of semiconductor device 103 extend between a third source or drain region 112a and a fourth source or drain region 112b). Figure 1B also illustrates spacer structures 114 that extend around the ends of nanoribbons 104 and along sidewalls of the gate structures between spacer structures 114. Spacer structures 114 may include a dielectric material, such as silicon nitride.

According to some embodiments, the source or drain regions are epitaxial regions that are provided using an etch-and-replace process. In other embodiments any of the source or drain regions could be, for example, implantation-doped native portions of the semiconductor fins or substrate. Any semiconductor materials suitable for the source or drain regions can be used (e.g., group IV and group III-V semiconductor materials). The source or drain regions may include multiple layers such as liners and capping layers to improve contact resistance. In any such cases, the composition and doping of the source or drain regions may be the same or different, depending on the polarity of the transistors. In an example, for instance, one transistor is a p-type MOS (PMOS) transistor, and the other transistor is an n-type MOS (NMOS) transistor. Any number of source and drain configurations and materials can be used.

According to some embodiments, a first gate structure extends over nanoribbons 104 of semiconductor device 101 along a second direction across the page while a second gate structure extends over nanoribbons 104 of semiconductor device 103 along the second direction. The second direction may be orthogonal to the first direction. Each gate structure includes a respective gate dielectric 116a/116b and a gate electrode (or gate layer) 118a/118b. Gate dielectric 116a/116b represents any number of dielectric layers present between nanoribbons 104 and gate layer 118a/118b. Gate dielectric 116a/116b may also be present on the surfaces of other structures within the gate trench, such as on subfin region 108. Gate dielectric 1 16a/116b may include any suitable gate dielectric material(s). In some embodiments, gate dielectric 116a/116b includes a layer of native oxide material (e.g., silicon dioxide) on the nanoribbons or other semiconductor regions making up the channel region of the devices, and a layer of high-K dielectric material (e.g., hafnium oxide) on the native oxide.

Gate electrode 118a/118b may represent any number of conductive layers, such as any metal, metal alloy, or doped polysilicon layers. In some embodiments, gate electrode 118a/118b includes one or more workfunction metals around nanoribbons 104. In some embodiments, one of semiconductor devices 101 and 103 is a p-channel device that include a workfunction metal having titanium around its nanoribbons 104 and the other semiconductor device is an n-channel device that includes a workfunction metal having tungsten around its nanoribbons 104. Gate electrode 118a/118b may also include a fill metal or other conductive material (e.g., tungsten, ruthenium, molybdenum, copper, aluminum) around the workfunction metals to provide the whole gate electrode structure. In some embodiments, a gate cap 119 may be formed over gate electrode 118a/118b to protect the underlying material during processing. Gate cap 119 may be any suitable dielectric material, such as silicon nitride.

According to some embodiments, adjacent gate structures may be separated along the second direction (e.g., across the page) by a gate cut 120, which acts like a dielectric barrier or wall between gate structures. Gate cut 120 extends vertically (e.g., in a third direction) through at least an entire thickness of the adjacent gate structure. In some embodiments, gate cut 120 also extends through an entire thickness of dielectric fill 106. According to some embodiments, gate cut 120 is formed from various dielectric materials. For example, gate cut 120 includes a dielectric layer 122 along an outer edge of gate cut 120 and a dielectric fill 124 on dielectric layer 122 and within an inner portion of gate cut 120. According to some embodiments, dielectric layer 122 includes a high-k dielectric material, such as silicon nitride or aluminum oxide, and dielectric fill 124 includes a low-k dielectric material, such as silicon dioxide, porous silicon dioxide, or flowable oxide. Dielectric layer 122 may be conformal and have a thickness between about 3 nm and about 7 nm. According to some embodiments, dielectric fill 124 does not extend to the top surface of gate cut 120. A top surface of dielectric fill 124 is below a respective top surface of the adjacent gate structure(s). Gate cut 120 may have a top width along the second direction between about 25 nm and about 50 nm.

According to some embodiments, a top portion of gate cut 120 includes a first conductive structure 126 on a top surface of dielectric fill 124. First conductive structure 126 may contact dielectric layer 122 on both sides of gate cut 120, such that first conductive structure 126 is separated from the adjacent gate electrodes 118a/118b by dielectric layer 122. According to some embodiments, first conductive structure 126 has a height within gate cut 120 of between about 30 nm and about 150 nm. Other embodiments may have different geometry. According to some embodiments, first conductive structure 126 includes any suitable conductive material, such as titanium, tantalum, ruthenium, molybdenum, cobalt, or tungsten, to name a few examples. First conductive structure 126 may include any number of conductive layers, such as a conductive liner and a conductive fill on the conductive liner, or just a conductive fill.

According to some embodiments, an interconnect region 128 is formed over semiconductor devices 101 and 103 and may include any number of interconnect layers. Each interconnect layer may include a dielectric layer along with any number of conductive vias and/or traces within the dielectric layer. In some examples, a second conductive structure 130 is on a top surface of first conductive structure 126. Second conductive structure 130 may be part of a first interconnect layer or a local interconnect layer directly above the device layer. According to some embodiments, second conductive structure 130 includes any of the materials disclosed above for first conductive structure 126. In some embodiments, a third conductive structure 132 is on a top surface of second conductive structure 130, and may also include any of the materials disclosed above for first conductive structure 126. Third conductive structure 132 may have a greater width along the second direction than either first conductive structure 126 or second conductive structure 130. For example, third conductive structure 132 may be at least 25%, at least 50%, at least 75%, or at least 100% wider than each of first conductive structure 126 and second conductive structure 130.

Interconnect region 128 includes a metal line 134, which may represent a first metal layer ( metal 0). According to some embodiments, the cross-section area of metal line 134 is increased by being directly coupled to the conductive structures beneath it, which includes at least first conductive structure 126 within gate cut 120. Any number of conductive structures may be present to link between metal line 134 and first conductive structure 126. In some embodiments, first conductive structure 126, second conductive structure 130, and third conductive structure 132 are collectively a single conductive structure that contacts metal line 134 and has a portion within gate cut 120.

Gate cut 120 also extends in the first direction as shown in Figure 1B such that it cuts across at least the entire width of the gate trench. According to some embodiments, gate cut 120 may also extend further past spacer structures 114. In some examples, gate cut 120 extends across more than one gate trench in the first direction (e.g., cutting through more than one gate structure running parallel along the second direction). First conductive structure 126 may extend along the entire length of gate cut 120 (e.g., along the first direction), or may terminate at designated locations along gate cut 120, as further described below.

### Fabrication Methodology

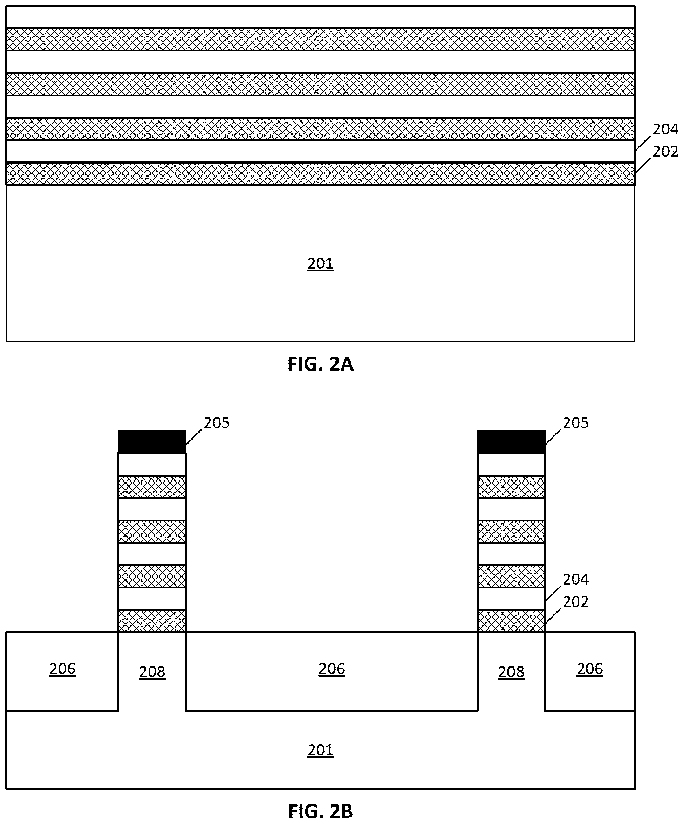

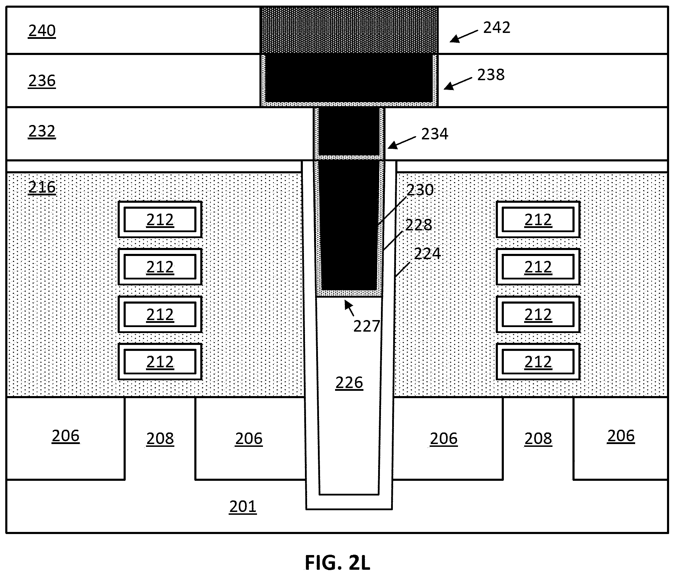

Figures 2A - 2L include cross-sectional views that collectively illustrate an example process for forming an integrated circuit with semiconductor devices and one or more gate cuts having a conductive structure within at least one of the gate cuts. Each figure shows an example structure that results from the process flow up to that point in time, so the depicted structure evolves as the process flow continues, culminating in the structure shown in Figure 2L, which is similar to the structure shown in Figure 1A. The illustrated integrated circuit structure may be part of a larger integrated circuit that includes other integrated circuitry not depicted. Example materials and process parameters are given, but the present disclosure is not intended to be limited to any specific such materials or parameters, as will be appreciated. Although the fabrication of a single gate cut is illustrated in the aforementioned figures, it should be understood that any number of similar gate cuts can be fabricated across the integrated circuit using the same processes discussed herein.

Figure 2A illustrates a cross-sectional view taken through a substrate 201 having a series of material layers formed over the substrate, according to an embodiment of the present disclosure. Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201. The description above for substrate 102 applies equally to substrate 201.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1nm). The thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

Figure 2B depicts the cross-section view of the structure shown in Figure 2A following the formation of a cap layer 205 and the subsequent formation of fins beneath cap layer 205, according to an embodiment. Cap layer 205 may be any suitable hard mask material such as a carbon hard mask (CHM) or silicon nitride. Cap layer 205 is patterned into rows to form corresponding rows of fins from the alternating layer stack of sacrificial layers 202 and semiconductor layers 204. The rows of fins extend lengthwise in a first direction (e.g., into and out of the page).

According to some embodiments, an anisotropic etching process through the layer stack continues into at least a portion of substrate 201. The etched portion of substrate 201 may be filled with a dielectric fill 206 that acts as shallow trench isolation (STI) between adjacent fins. Dielectric fill 206 may be any suitable dielectric material such as silicon dioxide. Subfin regions 208 represent remaining portions of substrate 201 between dielectric fill 206, according to some embodiments.

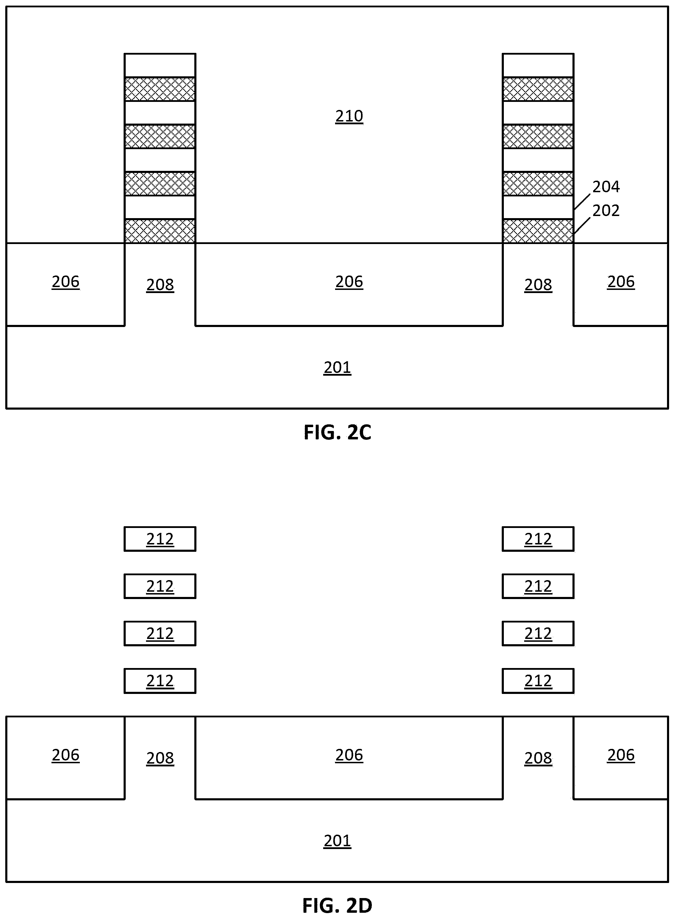

Figure 2C depicts the cross-section view of the structure shown in Figure 2B following the formation of a sacrificial gate 210 extending across the fins in a second direction different from the first direction, according to some embodiments. Sacrificial gate 210 may extend across the fins in a second direction that is orthogonal to the first direction. According to some embodiments, the sacrificial gate material is formed in parallel strips across the integrated circuit and removed in all areas not protected by a gate masking layer. Sacrificial gate 210 may be any suitable material that can be selectively removed without damaging the semiconductor material of the fins. In some examples, sacrificial gate 210 includes polysilicon. In some cases, sacrificial gate 210 may also include a gate dielectric, such as an oxide of the fin material.

Following the formation of sacrificial gate 210 (and prior to replacement of sacrificial gate 210 with a metal gate), additional semiconductor device structures are formed that are not shown in these cross-sections. These additional structures include spacer structures on the sidewalls of sacrificial gate 210 and source and drain regions on either ends of each of the fins. The formation of such structures can be accomplished using any number of processing techniques.

Figure 2D depicts the cross-section view of the structure shown in Figure 2C following the removal of sacrificial gate 210 and the removal of sacrificial layers 202, according to some embodiments. In examples where any gate masking layers are still present, they may also be removed at this time. Once sacrificial gate 210 is removed, the fins that had been beneath sacrificial gate 210 are exposed.

In the example where the fins include alternating semiconductor layers, sacrificial layers 202 are selectively removed to release nanoribbons 212 that extend between corresponding source or drain regions. Each vertical set of nanoribbons 212 represents the semiconductor or channel region of a different semiconductor device. It should be understood that nanoribbons 212 may also be nanowires or nanosheets (e.g., from a forksheet arrangement) or fins (e.g., for a finFET arrangement). Sacrificial gate 210 and sacrificial layers 202 may be removed using the same isotropic etching process or different isotropic etching processes.

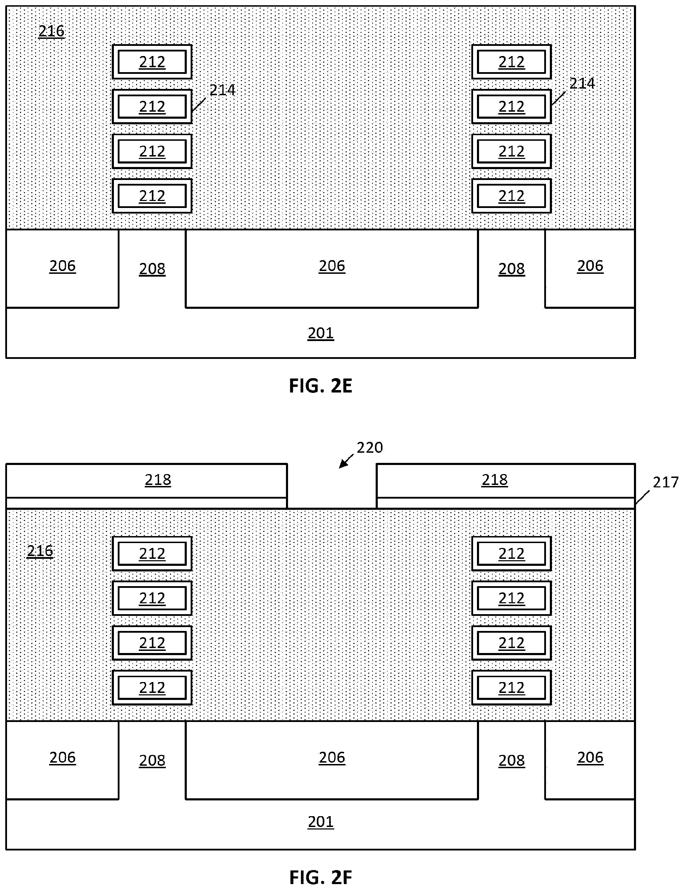

Figure 2E depicts the cross-section view of the structure shown in Figure 2D following the formation of a gate structure and subsequent polishing, according to some embodiments. The gate structure includes a gate dielectric 214 and a conductive gate electrode 216. Gate dielectric 214 may be first formed around nanoribbons 212 prior to the formation of gate electrode 216. The gate dielectric 214 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 214 includes a layer of hafnium oxide with a thickness between about 1 nm and about 5 nm. In some embodiments, gate dielectric 214 may include one or more silicates (e.g., titanium silicate, tungsten silicate, niobium silicate, and silicates of other transition metals). In some cases, gate dielectric 214 may include a first layer on nanoribbons 212, and a second layer on the first layer. The first layer can be, for instance, an oxide of the semiconductor material of nanoribbons 212 (e.g., silicon dioxide) and the second layer can be a high-k dielectric material (e.g., hafnium oxide). More generally, gate dielectric 214 can include any number of dielectric layers. According to some embodiments, gate dielectric 214 forms along all surfaces exposed within the gate trench, such as along inner sidewalls of the spacer structures and along the top surfaces of dielectric fill 206 and subfin regions 208.

As noted above, gate electrode 216 can represent any number of conductive layers. The conductive gate electrode 216 may be deposited using electroplating, electroless plating, CVD, PECVD, ALD, or PVD, to name a few examples. In some embodiments, gate electrode 216 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 216 may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Following the formation of the gate structure, the entire structure may be polished or planarized such that the top surface of the gate structure (e.g., top surface of gate electrode 216) is planar with the top surface of other semiconductor elements, such as the spacer structures that define the gate trench.

Figure 2F illustrates another cross-section view of the structure shown in Figure 2E following the formation of a masking structure 218, according to some embodiments. In some examples, a gate cap 217 is formed prior to masking structure 218. Gate electrode 216 may be recessed within the gate trench and gate cap 217 may be formed within the recess above gate electrode 216 within the gate trench. Gate cap 217 may be a dielectric material, such as silicon nitride, for protecting the underlying gate electrode 216. In some examples, gate cap 217 has a thickness between about 10 nm and about 20 nm, such as around 15 nm.

Masking structure 218 may include any number of hard mask layers, such as any dielectric layers or carbon hard mask layers. An opening 220 may be formed through masking structure 218 and gate cap 217 to expose a portion of gate electrode 216 where a gate cut will be formed. A reactive ion etching (RIE) process may be used to form opening 220, according to some examples.

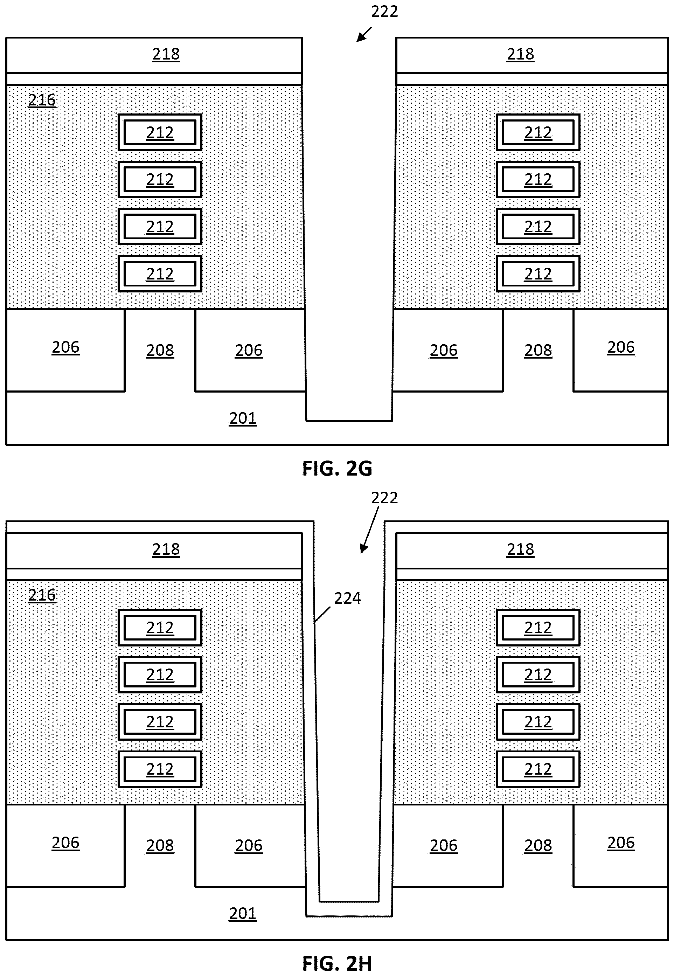

Figure 2G illustrates another cross-section view of the structure shown in Figure 2F following the formation of a gate cut recess 222 through at least an entire thickness of gate electrode 216, according to some embodiments. Gate cut recess 222 may have a high height-to-width aspect ratio of 5:1 or more, such as between 6:1 and 10:1 and may be formed via a series of RIE and passivation steps to etch through the conductive material of gate electrode 216. Gate cut recess 222 may be tapered and have a largest width along a top surface of gate electrode 216 between about 25 nm and about 50 nm. In some embodiments, gate cut recess 222 extends through an entire thickness of dielectric fill 206 and into the underlying substrate 201.

Figure 2H illustrates another cross-section view of the structure shown in Figure 2G following the formation of a dielectric layer 224 within gate cut recess 222, according to some embodiments. According to some embodiments, dielectric layer 224 includes a high-k dielectric material, such as silicon nitride, silicon oxynitride, silicon carbonitride, or silicon oxycarbonitride, or any other material having a dielectric constant of at least 6.5. Dielectric layer 224 may be, for example, conformally deposited using ALD to a thickness between about 3 nm and about 7 nm.

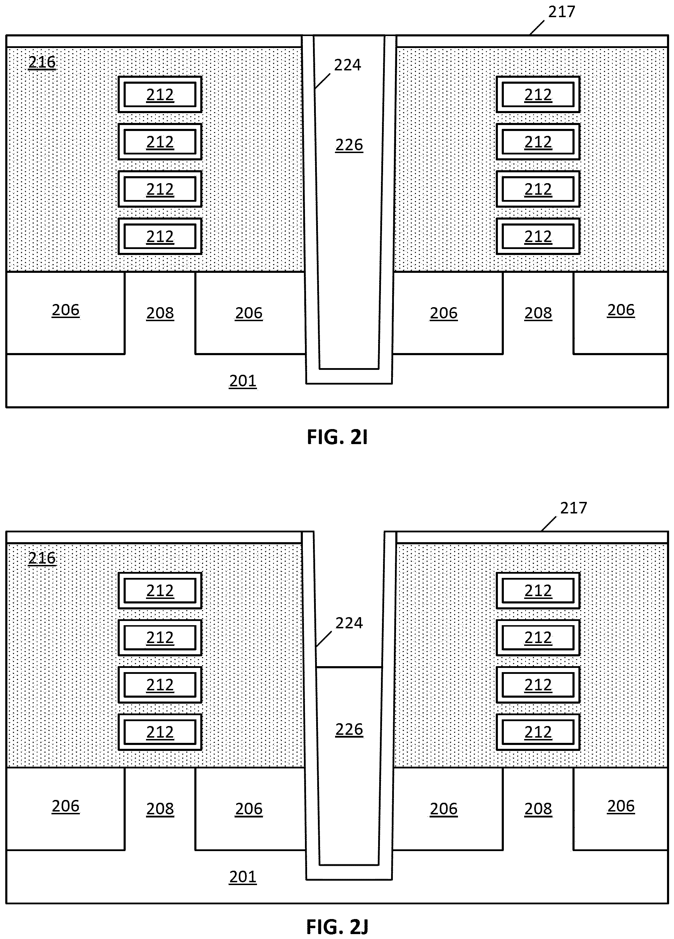

Figure 2I illustrates another cross-section view of the structure shown in Figure 2H following the formation of a dielectric fill 226 within a remaining volume of gate cut recess 222, according to some embodiments. Dielectric fill 226 may be formed directly on dielectric layer 224. According to some embodiments, dielectric fill 226 includes a low-k dielectric material, such as silicon dioxide or flowable oxide or any other material having a dielectric constant of at most 4.5. Dielectric fill 226 may be deposited using any suitable plasma deposition technique, such as via CVD. In still other example embodiments, dielectric fill 226 may be conformally deposited using ALD or CVD so as to pinch-off and close at or near the top of gate cut recess 222.

Dielectric fill 226 may overflow out of gate cut recess 222 and be polished back using chemical mechanical polishing (CMP), according to some embodiments. In the illustrated example, dielectric fill 226 is polished back to be substantially level or coplanar with a top surface of gate cap 217 (e.g., removing masking structure 218). For instance, the resulting top surface of dielectric fill 226 is within 10 angstroms of the top surface of gate cap 217.

Figure 2J illustrates another cross-section view of the structure shown in Figure 2I following the recessing of dielectric fill 226, according to some embodiments. Dielectric fill 226 may be recessed such that a top surface of dielectric fill 226 is at least below a top surface of gate electrode 216 or below a top surface of gate cap 217. Any plasma-based etching process or wet etching process may be used to recess dielectric fill 226. The depth of the recess dictates the height of the conductive structure formed within the gate cut and may range in depth depending on the application. In some examples, the recessed depth of dielectric fill 226 is between about 30 nm and about 150 nm.

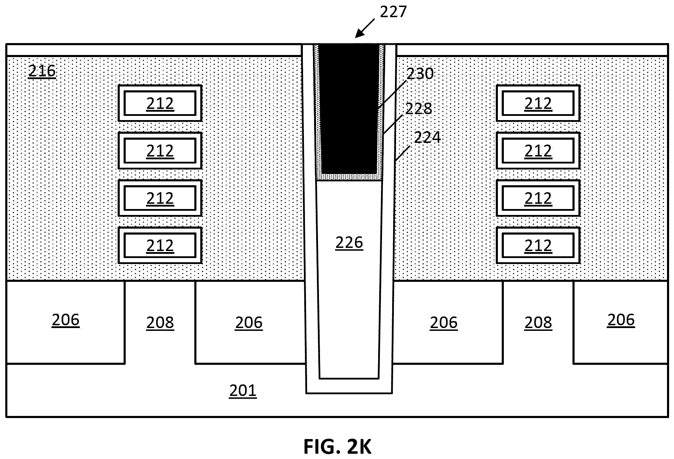

Figure 2K illustrates another cross-section view of the structure shown in Figure 2J following the formation of a first conductive structure 227 over dielectric fill 226 within the gate cut, according to some embodiments. First conductive structure 227 may be formed directly on dielectric fill 226 such that first conductive structure 227 substantially fills the volume that the recessed dielectric fill 226 had occupied. Excess material can be removed, for example, via CMP such that the resulting top surface of first conductive structure 227 substantially coplanar (e.g., within 10 angstroms) of the top surface of the gate structure (which in this example is the top surface of gate cap 217). According to some embodiments, first conductive structure 227 includes a conductive liner 228 and a conductive fill 230 on the conductive liner.

Conductive liner 228 may include any suitable conductive material, such as titanium or tantalum, or a nitride thereof, and may be deposited to a thickness between about 1 nm and about 5 nm. Conductive liner 228 may be deposited using CVD to conformally cover all exposed surfaces within the recess above dielectric fill 226. Conductive fill 230 may include any suitable conductive material, such as ruthenium, tungsten, molybdenum, or cobalt and may be formed directly on conductive liner 228 and substantially fill a remaining volume of the recess above dielectric fill 226.

Figure 2L illustrates another cross-section view of the structure shown in Figure 2K following the formation of any number of interconnect layers above the semiconductor devices. Each interconnect layer includes a dielectric layer and any number of conductive structures that route signal or power around the integrated circuit. According to some embodiments, one or more other conductive structures are formed above first conductive structure 227 within the interconnect region.

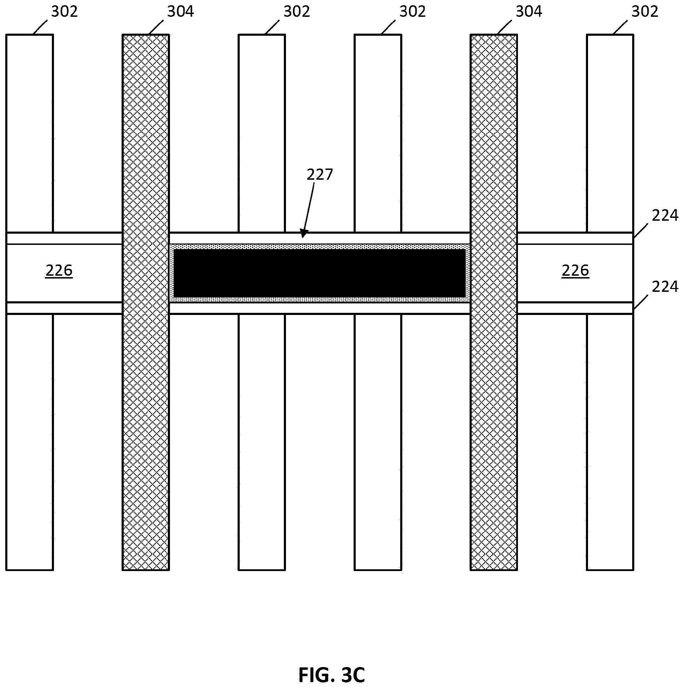

A first interconnect layer includes a first interconnect dielectric 232 and a second conductive structure 234, according to some embodiments. First interconnect dielectric 232 may include any suitable dielectric material, such as silicon dioxide. Second conductive structure 234 may have substantially the same properties as first conductive structure 227. Accordingly, second conductive structure 234 may also include a conductive liner and a conductive fill in some examples, or just conductive fill in some other examples. Second conductive structure 234 may be directly on a top surface of first conductive structure 227 (e.g., directly on a top surface of conductive fill 230). The width (in second direction) and length (in first direction) of conductive structure 234 can vary from one example to the next. According to some embodiments, the width of second conductive structure 234 across the second direction is substantially the same as a width of the top surface of first conductive structure 227. In some such embodiments, dielectric layer 224 provides a buffer zone to help prevent shorting of conductive structure 234 to gate electrode 216. According to some embodiments, the length of second conductive structure 234 in the first direction runs from a first gate trench (behind the gate trench depicted) to a second gate trench (in front of the gate trench depicted). In some such cases, the first and/or second gate trench can be filled with dielectric material to provide an isolation structure or two. In such a case, first conductive structure 227 can be contained in the first direction between corresponding first and second isolation structures (e.g., as shown in the example case of Figure 3C).

A second interconnect layer includes a second interconnect dielectric 236, similar to first interconnect dielectric 232, and a third conductive structure 238, according to some embodiments. Third conductive structure 238 may have substantially the same properties as first conductive structure 227. Accordingly, third conductive structure 238 may also include a conductive liner and a conductive fill. Third conductive structure 238 may be directly on a top surface of second conductive structure. According to some embodiments, a width of third conductive structure 238 across the second direction is greater than a width of first conductive structure 227 and second conductive structure 234. For example, third conductive structure 238 may be at least 25%, at least 50%, at least 75%, or at least 100% wider than first conductive structure 227 and second conductive structure 234.

In the illustrated embodiment, second conductive structure 234 and third conductive structure 238 are formed as separate structures within separate dielectric layers. However, in some embodiments, second conductive structure 234 and third conductive structure 238 are formed as a single conductive structure using, for example, a dual damascene process.

According to some embodiments, a third interconnect layer includes a third interconnect dielectric 240, similar to first interconnect dielectric 232, and a metal line 242 that may represent a first metal layer (e.g., metal 0). Accordingly, metal line 242 may include any common conductive material used for interconnects, such as copper or tungsten. In some examples, a width of metal line 242 along the second direction is substantially the same as the width of third conductive structure 238. In some applications, metal line 242 is a power or ground rail that runs along a cell boundary (e.g., along the first direction). In the illustrated embodiment, the effective cross-section area of metal line 242 is increased due to its connection with first conductive structure 227, second conductive structure 234, and third conductive structure 238.

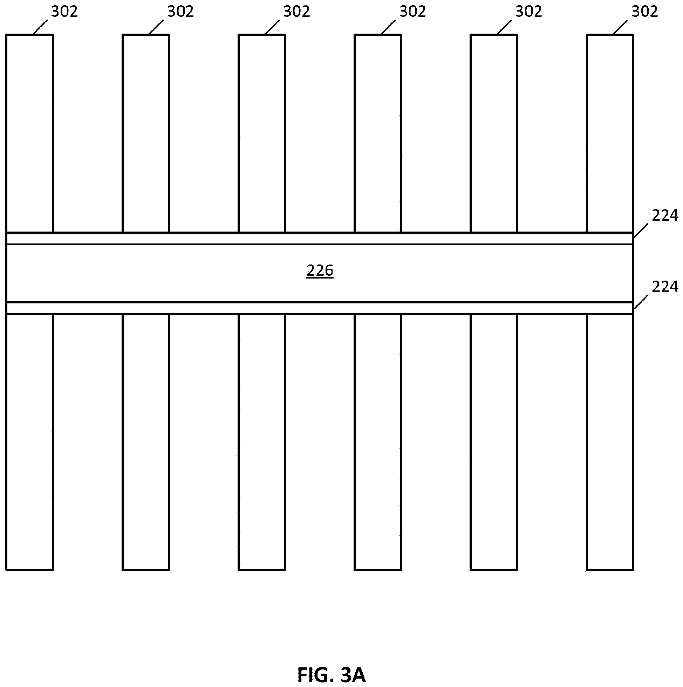

Figures 3A - 3C illustrate plan views of portions of the process described in Figures 2A - 2L that show how first conductive structure 227 is terminated at selected regions within the integrated circuit, according to some embodiments. The semiconductor regions and source or drain regions from the various transistors are omitted in these illustrations for clarity. Figure 3A illustrates a plurality of gate trenches 302 extending parallel to one another along a second direction and a gate cut extending in a first direction orthogonally across gate trenches 302. The sidewalls of the gate cut include dielectric layer 224 while the center of the gate cut includes dielectric fill 226. Gate trenches 302 may represent gate structures complete with gate electrodes and gate dielectrics. In some embodiments, gate trenches 302 represent strips of sacrificial gate material, as the case may be when the gate cut is formed before the replacement of the sacrificial gates with the conductive gate structures.

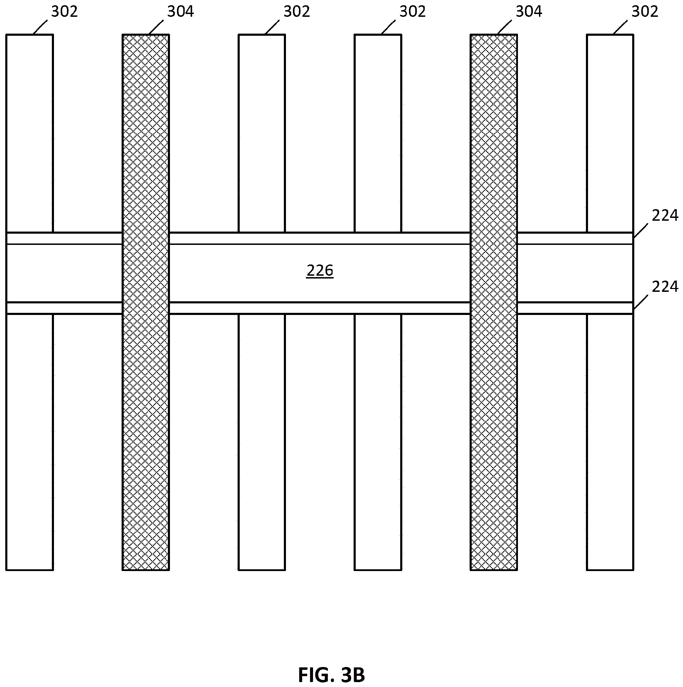

Figure 3B illustrates another plan view of the structure shown in Figure 3A following the formation of isolation structures 304 within one or more of gate trenches 302, according to some embodiments. An RIE process may be performed to remove all material within selected gate trenches. The cleared trenches may then be filled with a dielectric material to form isolation structures 304, which run parallel to the other gate trenches 302. Any suitable dielectric material may be used for isolation structures 304, such as silicon nitride or silicon oxycarbonitride, or any dielectric material having a high etch rate selectivity compared with the dielectric material used for dielectric fill 226.

According to some embodiments, isolation structures 304 are used to set the termination points for first conductive structure 227 within the gate cut. Figure 3C illustrates another plan view of the structure shown in Figure 3B following the formation of first conductive structure 227 within the gate cut and between isolation structures 304. The presence of isolation structures 304 creates a well of dielectric fill 226 between them with its perimeter surrounded by dielectric layer 224 and isolation structures 304. Accordingly, dielectric fill 226 can be safely recessed while etching little to none of the surrounding dielectric material from dielectric layer 224 and isolation structures 304.

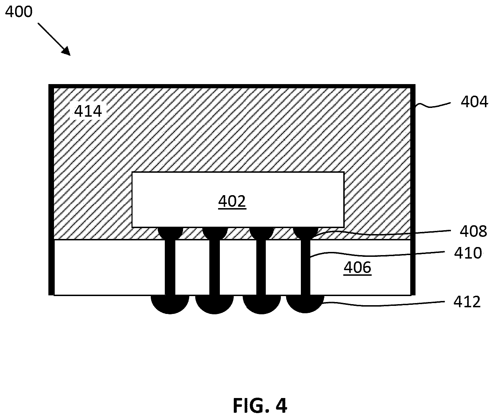

Figure 4 illustrates an example embodiment of a chip package 400, in accordance with an embodiment of the present disclosure. As can be seen, chip package 400 includes one or more dies 402. One or more dies 402 may include at least one integrated circuit having semiconductor devices, such as any of the semiconductor devices disclosed herein. One or more dies 402 may include any other circuitry used to interface with other devices formed on the dies, or other devices connected to chip package 400, in some example configurations.

As can be further seen, chip package 400 includes a housing 404 that is bonded to a package substrate 406. The housing 404 may be any standard or proprietary housing, and may provide, for example, electromagnetic shielding and environmental protection for the components of chip package 400. The one or more dies 402 may be conductively coupled to a package substrate 406 using connections 408, which may be implemented with any number of standard or proprietary connection mechanisms, such as solder bumps, ball grid array (BGA), pins, or wire bonds, to name a few examples. Package substrate 406 may be any standard or proprietary package substrate, but in some cases includes a dielectric material having conductive pathways (e.g., including conductive vias and lines) extending through the dielectric material between the faces of package substrate 406, or between different locations on each face. In some embodiments, package substrate 406 may have a thickness less than 1 millimeter (e.g., between 0.1 millimeters and 0.5 millimeters), although any number of package geometries can be used. Additional conductive contacts 412 may be disposed at an opposite face of package substrate 406 for conductively contacting, for instance, a printed circuit board (PCB). One or more vias 410 extend through a thickness of package substrate 406 to provide conductive pathways between one or more of connections 408 to one or more of contacts 412. Vias 410 are illustrated as single straight columns through package substrate 406 for ease of illustration, although other configurations can be used (e.g., damascene, dual damascene, through-silicon via, or an interconnect structure that meanders through the thickness of substrate 406 to contact one or more intermediate locations therein). In still other embodiments, vias 410 are fabricated by multiple smaller stacked vias, or are staggered at different locations across package substrate 406. In the illustrated embodiment, contacts 412 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 412, to inhibit shorting.

In some embodiments, a mold material 414 may be disposed around the one or more dies 402 included within housing 404 (e.g., between dies 402 and package substrate 406 as an underfill material, as well as between dies 402 and housing 404 as an overfill material). Although the dimensions and qualities of the mold material 414 can vary from one embodiment to the next, in some embodiments, a thickness of mold material 414 is less than 1 millimeter. Example materials that may be used for mold material 414 include epoxy mold materials, as suitable. In some cases, the mold material 414 is thermally conductive, in addition to being electrically insulating.

### Methodology

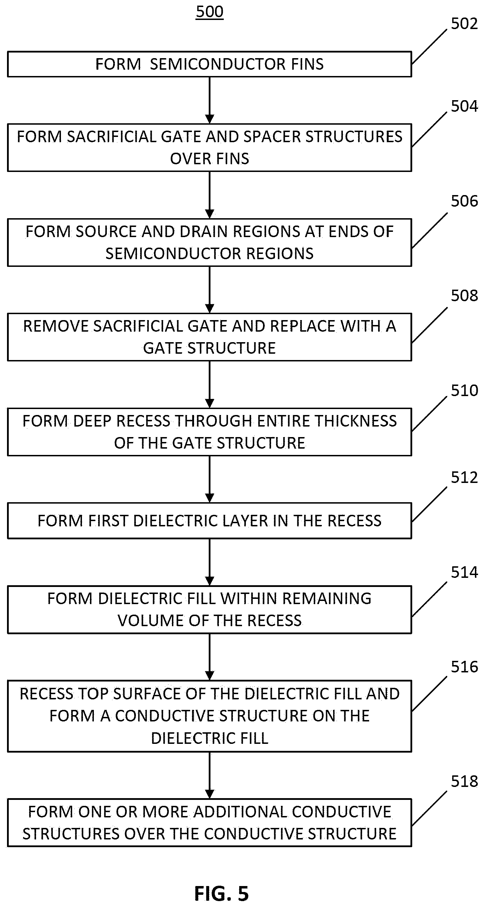

Figure 5 is a flow chart of a method 500 for forming at least a portion of an integrated circuit, according to an embodiment. Various operations of method 500 may be illustrated in Figures 2A - 2L. However, the correlation of the various operations of method 500 to the specific components illustrated in the aforementioned figures is not intended to imply any structural and/or use limitations. Rather, the aforementioned figures provide one example embodiment of method 500. Other operations may be performed before, during, or after any of the operations of method 500. For example, method 500 does not explicitly describe all processes that are performed to form common transistor structures. Some of the operations of method 500 may be performed in a different order than the illustrated order.

Method 500 begins with operation 502 where any number of parallel semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride.

According to some embodiments, a dielectric layer is formed around subfin portions of the one or more fins. In some embodiments, the dielectric layer extends between each pair of adjacent parallel fins and runs lengthwise in the same direction as the fins. In some embodiments, the anisotropic etching process that forms the fins also etches into a portion of the substrate and the dielectric layer may be formed within the recessed portions of the substrate. Accordingly, the dielectric layer acts as shallow trench isolation (STI) between adjacent fins. The dielectric layer may be any suitable dielectric material, such as silicon dioxide.

Method 500 continues with operation 504 where a sacrificial gate and spacer structures are formed over the fins. The sacrificial gate may be patterned using a gate masking layer in a strip that runs orthogonally over the fins (many gate masking layers and corresponding sacrificial gates may be formed parallel to one another (e.g., forming a crosshatch pattern with the fins). The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon. The spacer structures may be deposited and then etched back such that the spacer structures remain mostly only on sidewalls of any exposed structures. According to some embodiments, the spacer structures may be any suitable dielectric material, such as silicon nitride or silicon oxynitride.

Method 500 continues with operation 506 where source or drain regions are formed at the ends of the semiconductor regions of each of the fins. Any portions of the fins not protected by the sacrificial gate and spacer structures may be removed using, for example, an anisotropic etching process followed by the epitaxial growth of the source or drain regions from the exposed ends of the semiconductor layers in the fins. In some example embodiments, the source or drain regions are NMOS source or drain regions (e.g., epitaxial silicon) or PMOS source or drain regions (e.g., epitaxial SiGe). Another dielectric fill may be formed adjacent to the various source or drain regions for additional electrical isolation between adjacent regions. The dielectric fill may also extend over a top surface of the source or drain regions. In some embodiments, topside conductive contacts may be formed through the dielectric fill to contact one or more of the source or drain regions.

Method 500 continues with operation 508 where the sacrificial gate is removed and replaced with a gate structure. The sacrificial gate may be removed using an isotropic etching process that selectively removes all of the material from the sacrificial gate, thus exposing the various fins between the set of spacer structures. In the example case where GAA transistors are used, any sacrificial layers within the exposed fins between the spacer structures may also be removed to release nanoribbons, nanosheets, or nanowires of semiconductor material.

The gate structure may include both a gate dielectric and a gate electrode. The gate dielectric is first formed over the exposed semiconductor regions between the spacer structures followed by forming the gate electrode within the remainder of the trench between the spacer structures, according to some embodiments. The gate dielectric may include any number of dielectric layers deposited using a CVD process, such as ALD. The gate electrode can include any number of conductive material layers, such as any metals, metal alloys, or polysilicon. The gate electrode may be deposited using electroplating, electroless plating, CVD, ALD, PECVD, or PVD, to name a few examples. In some embodiments, the gate electrode may be recessed, and a dielectric gate cap is formed within the recessed area. The dielectric gate cap may have a thickness between 10 nm and 20 nm, such as around 15 nm. Further, recall from the description of Figures 3A-3C that one or more of the gate structures may be converted to a dielectric wall or isolation structure.

Method 500 continues with operation 510 where a deep recess is formed through an entire thickness of the gate structure. A mask structure may be formed over the gate structure and an opening may be formed through the mask structure to expose a portion of the underlying gate electrode. According to some embodiments, the opening through the mask structure is at a location where the deep recess is to be formed through the underlying gate electrode. The mask structure may include any number of hard mask layers, such as any dielectric layers or carbon hard mask layers. The opening may be formed using a directional RIE process. According to some embodiments, the deep recess has a high height-to-width aspect ratio of at least 6:1 and extends through at least an entire thickness of the gate structure. In some examples, the deep recess also extends through an entire thickness of the dielectric fill between devices and into the underlying substrate.

Method 500 continues with operation 512 where a dielectric layer is formed within the recess and on the exposed sidewalls of the gate electrode. According to some embodiments, the dielectric layer includes a high-k dielectric material, such as silicon nitride or silicon carbide or any other material having a dielectric constant of at least 6.5. The dielectric layer may be deposited, for example, using ALD to a thickness between about 2 nm and about 4 nm.

Method 500 continues with operation 514 where a dielectric fill is formed within the recess and on the dielectric layer. According to some embodiments, the dielectric fill includes a low-k dielectric material, such as silicon dioxide or flowable oxide or any other material having a dielectric constant of at most 4.5. The dielectric fill may be polished back until a top surface of the dielectric fill is level with a top surface of the mask structure or with a top surface of the dielectric gate cap on the gate electrode. In some examples, the dielectric fill is flowable silicon dioxide and the dielectric layer is silicon nitride.

Method 500 continues with operation 516 where the dielectric fill is recessed and a conductive structure is formed on the dielectric fill. The dielectric fill may be recessed via any number of wet or dry etching processes. In some examples, a top surface of the dielectric fill is recessed such that it at least falls below a top surface of the gate electrode. In some embodiments, the top surface of the dielectric fill is recessed such that it is between 30 nm and 150 below the top surface of the gate electrode or the top surface of a dielectric cap on the gate electrode.

According to some embodiments, a conductive structure is formed on a top surface of the recessed dielectric fill. The conductive structure may include any number of different conductive materials, such as a conductive liner and a conductive fill on the conductive liner. The conductive liner may include any suitable conductive material, such as titanium or tantalum, and may be deposited to a thickness between about 1 nm and about 5 nm, in some such examples. The conductive liner may be deposited using CVD to conformally cover all exposed surfaces within the recess above the dielectric fill. The conductive fill may include any suitable conductive material, such as ruthenium, tungsten, molybdenum, or cobalt and may be formed directly on the conductive liner within a remaining volume of the recess above the dielectric fill.

Method 500 continues with operation 518 where one or more additional conductive structures are formed over the conductive structure. The one or more additional conductive structures may have the same general properties as the conductive structure. According to some embodiments, the one or more additional conductive structures are formed within an interconnect region above the semiconductor devices. The one or more additional conductive structures may provide a conductive link between the conductive structure within the gate cut and a metal line within the interconnect region. The metal line may be used as a power or ground rail within the integrated circuit.

### Example System

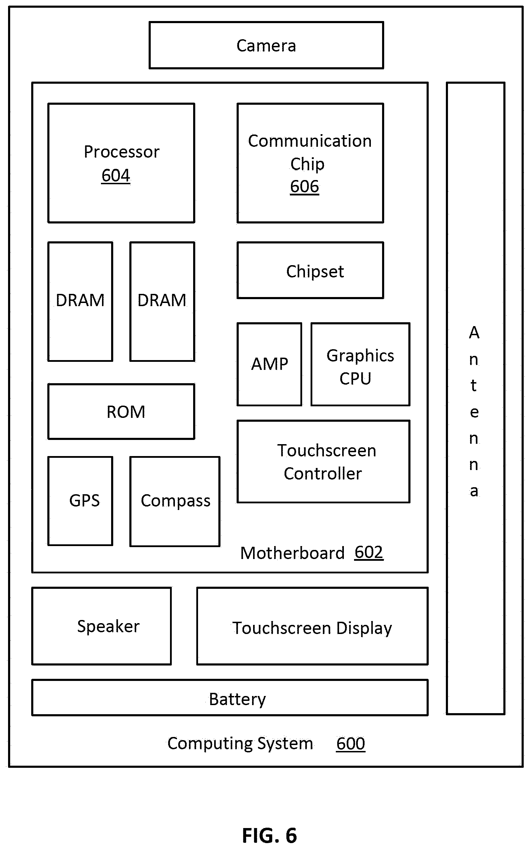

FIG. 6 is an example computing system implemented with one or more of the integrated circuit structures as disclosed herein, in accordance with some embodiments of the present disclosure. As can be seen, the computing system 600 houses a motherboard 602. The motherboard 602 may include a number of components, including, but not limited to, a processor 604 and at least one communication chip 606, each of which can be physically and electrically coupled to the motherboard 602, or otherwise integrated therein. As will be appreciated, the motherboard 602 may be, for example, any printed circuit board (PCB), whether a main board, a daughterboard mounted on a main board, or the only board of system 600, etc.

Depending on its applications, computing system 600 may include one or more other components that may or may not be physically and electrically coupled to the motherboard 602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 600 may include one or more integrated circuit structures or devices configured in accordance with an example embodiment, such as a module including an integrated circuit on a substrate, the substrate having semiconductor devices and at least one gate cut having an interconnect structure, or a portion thereof, within the gate cut. In some embodiments, multiple functions can be integrated into one or more chips (e.g., for instance, note that the communication chip 606 can be part of or otherwise integrated into the processor 604).

The communication chip 606 enables wireless communications for the transfer of data to and from the computing system 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing system 600 includes an integrated circuit die packaged within the processor 604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 606 also may include an integrated circuit die packaged within the communication chip 606. In accordance with some such example embodiments, the integrated circuit die of the communication chip includes one or more semiconductor devices as variously described herein. As will be appreciated in light of this disclosure, note that multi-standard wireless capability may be integrated directly into the processor 604 (e.g., where functionality of any chips 606 is integrated into processor 604, rather than having separate communication chips). Further note that processor 604 may be a chip set having such wireless capability. In short, any number of processor 604 and/or communication chips 606 can be used. Likewise, any one chip or chip set can have multiple functions integrated therein.

In various implementations, the computing system 600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a semiconductor device having a semiconductor region extending in a first direction from a source or drain region, a gate structure extending in a second direction over the semiconductor region, and a gate cut adj acent to the semiconductor device and extending along the first direction and along a third direction through an entire height of the gate structure. The gate cut includes a dielectric layer along edges of the gate cut and a dielectric fill on the dielectric layer. A top surface of the dielectric fill is below a top surface of the gate structure. The integrated circuit also includes a conductive structure on a top surface of the dielectric fill such that sidewalls of the conductive structure contact the dielectric layer.

Example 2 includes the integrated circuit of Example 1, further comprising a dielectric cap layer on a top surface of the gate structure, wherein a top surface of the conductive structure is substantially coplanar with a top surface of the dielectric cap layer.

Example 3 includes the integrated circuit of Example 1 or 2, wherein the conductive structure comprises a conductive liner directly on the dielectric fill and the dielectric layer, and a conductive fill on the conductive liner.

Example 4 includes the integrated circuit of Example 3, wherein the conductive liner comprises titanium and nitrogen.

Example 5 includes the integrated circuit of Example 3 or 4, wherein the conductive fill comprises any one of tungsten, ruthenium, molybdenum, or cobalt.

Example 6 includes the integrated circuit of any one of Examples 1-5, wherein the conductive structure is a first conductive structure, and the integrated circuit further comprises a second conductive structure on a top surface of the first conductive structure.

Example 7 includes the integrated circuit of Example 6, wherein the integrated circuit further comprises a third conductive structure on a top surface of the second conductive structure, the third conductive structure having a greater width along the second direction than both of the first conductive structure and the second conductive structure.

Example 8 includes the integrated circuit of any one of Examples 1-7, wherein a width of the gate cut along the second direction is between about 25 nm and about 50 nm.

Example 9 includes the integrated circuit of any one of Examples 1-8, wherein the semiconductor region comprises a plurality of semiconductor nanoribbons.

Example 10 includes the integrated circuit of Example 9, wherein the plurality of semiconductor nanoribbons comprise germanium, silicon, or a combination thereof.

Example 11 includes the integrated circuit of any one of Examples 1-10, wherein the conductive structure extends along the first direction until terminating at a dielectric structure that extends in the second direction across the gate cut.

Example 12 includes the integrated circuit of Example 11, wherein the dielectric structure comprises a different dielectric material than the dielectric fill.

Example 13 includes the integrated circuit of Example 11 or 12, wherein the dielectric structure comprises silicon and nitrogen and the dielectric fill comprises silicon and oxygen.

Example 14 is a printed circuit board comprising the integrated circuit of any one of Examples 1-13.

Example 15 is an electronic device that includes a chip package having one or more dies. At least one of the one or more dies includes a semiconductor region extending in a first direction from a source or drain region, a gate structure extending in a second direction over the semiconductor region, and a gate cut adjacent to the semiconductor device and extending along the first direction and along a third direction through an entire height of the gate structure. The gate cut includes a dielectric layer along edges of the gate cut and a dielectric fill on the dielectric layer. A top surface of the dielectric fill is below a top surface of the gate structure. The integrated circuit also includes a conductive structure on a top surface of the dielectric fill such that sidewalls of the conductive structure contact the dielectric layer.

Example 16 includes the electronic device of Example 15, wherein the at least one of the one or more dies further comprises a dielectric cap layer on a top surface of the gate structure, wherein a top surface of the conductive structure is substantially coplanar with a top surface of the dielectric cap layer.

Example 17 includes the electronic device of Example 15 or 16, wherein the conductive structure comprises a conductive liner directly on the dielectric fill and the dielectric layer, and a conductive fill on the conductive liner.

Example 18 includes the electronic device of Example 17, wherein the conductive liner comprises titanium and nitrogen.

Example 19 includes the electronic device of Example 17 or 18, wherein the conductive fill comprises any one of tungsten, ruthenium, molybdenum, or cobalt.

Example 20 includes the electronic device of any one of Examples 15-19, wherein the conductive structure is a first conductive structure, and the at least one of the one or more dies further comprises a second conductive structure on a top surface of the first conductive structure.

Example 21 includes the electronic device of Example 20, wherein the at least one of the one or more dies further comprises a third conductive structure on a top surface of the second conductive structure, the third conductive structure having a greater width along the second direction than both of the first conductive structure and the second conductive structure.

Example 22 includes the electronic device of any one of Examples 15-21, wherein a width of the gate cut along the second direction is between about 25 nm and about 50 nm.

Example 23 includes the electronic device of any one of Examples 15-22, wherein the semiconductor region comprises a plurality of semiconductor nanoribbons.

Example 24 includes the electronic device of Example 23, wherein the plurality of semiconductor nanoribbons comprise germanium, silicon, or a combination thereof.

Example 25 includes the electronic device of any one of Examples 15-24, wherein the conductive structure extends along the first direction until terminating at a dielectric structure that extends in the second direction across the gate cut.

Example 26 includes the electronic device of Example 25, wherein the dielectric structure comprises a different dielectric material than the dielectric fill.

Example 27 includes the electronic device of Example 25 or 26, wherein the dielectric structure comprises silicon and nitrogen and the dielectric fill comprises silicon and oxygen.

Example 28 includes the electronic device of any one of Examples 15-27, further comprising a printed circuit board, wherein the chip package is coupled to the printed circuit board.

Example 29 is a method of forming an integrated circuit. The method includes forming one or more fins comprising semiconductor material, the one or more fins extending above a substrate and each extending parallel to one another in a first direction; forming a gate electrode extending over the semiconductor material in a second direction different from the first direction; forming a recess extending across the gate electrode in the first direction and extending in a third direction through an entire height of the gate electrode; forming a dielectric layer within the recess; forming a dielectric fill within a remaining volume of the recess and on the dielectric layer; recessing a top surface of the dielectric fill to form a partial recess; and forming a conductive structure on the top surface of the dielectric fill within the partial recess.

Example 30 includes the method of Example 29, wherein forming the conductive structure comprises forming a conductive liner within the partial recess, and forming a conductive fill on the conductive liner.

Example 31 includes the method of Example 29 or 30, further comprising forming source and drain regions at ends of the semiconductor material.

Example 32 includes the method of any one of Examples 29-31, wherein the conductive structure is a first conductive structure and the method further comprises forming a second conductive structure on the first conductive structure, and forming a third conductive structure on the second conductive structure, wherein the third conductive structure has a greater width along the second direction than both of the first conductive structure and second conductive structure.

Example 33 is an integrated circuit that includes a semiconductor device having a semiconductor region extending in a first direction from a source or drain region, a gate structure extending in a second direction over the semiconductor region, and a gate cut adjacent to the semiconductor device and extending along the first direction and along a third direction through an entire height of the gate structure. The gate cut includes a dielectric layer along edges of the gate cut and a dielectric fill on the dielectric layer. A top surface of the dielectric fill is below a top surface of the gate structure. The integrated circuit also includes a conductive structure that includes a first conductive portion on the dielectric fill and having sidewalls that contact the dielectric layer, a second conductive portion on the first conductive portion, and a third conductive portion on the second conductive portion. The third conductive portion has a greater width along the second direction than both of the first conductive portion and the second conductive portion.

Example 34 includes the integrated circuit of Example 33, further comprising a dielectric cap layer on a top surface of the gate structure, wherein a top surface of the first conductive portion is substantially coplanar with a top surface of the dielectric cap layer.

Example 35 includes the integrated circuit of Example 33 or 34, wherein the first conductive portion comprises a conductive liner directly on the dielectric fill and the dielectric layer, and a conductive fill on the conductive liner.

Example 36 includes the integrated circuit of Example 35, wherein the conductive liner comprises titanium and nitrogen.

Example 37 includes the integrated circuit of Example 35 or 36, wherein the conductive fill comprises any one of tungsten, ruthenium, molybdenum, or cobalt.

Example 38 includes the integrated circuit of any one of Examples 33-37, wherein a width of the gate cut along the second direction is between about 25 nm and about 50 nm.

Example 39 includes the integrated circuit of any one of Examples 33-38, wherein the semiconductor region comprises a plurality of semiconductor nanoribbons.

Example 40 includes the integrated circuit of Example 39, wherein the plurality of semiconductor nanoribbons comprise germanium, silicon, or a combination thereof.

Example 41 includes the integrated circuit of any one of Examples 33-40, wherein the first conductive portion extends along the first direction until terminating at a dielectric structure that extends in the second direction across the gate cut.

Example 42 includes the integrated circuit of Example 41, wherein the dielectric structure comprises a different dielectric material than the dielectric fill.

Example 43 includes the integrated circuit of Example 41 or 42, wherein the dielectric structure comprises silicon and nitrogen and the dielectric fill comprises silicon and oxygen.

Example 44 is a printed circuit board that includes the integrated circuit of any one of Examples 33-43.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a semiconductor device having a semiconductor region extending in a first direction from a source or drain region, and a gate structure extending in a second direction over the semiconductor region;
a gate cut adjacent to the semiconductor device and extending along the first direction and along a third direction through an entire height of the gate structure, the gate cut comprising
a dielectric layer along edges of the gate cut, and
a dielectric fill on the dielectric layer, wherein a top surface of the dielectric fill is below a top surface of the gate structure; and
a conductive structure on a top surface of the dielectric fill such that sidewalls of the conductive structure contact the dielectric layer.

2. The integrated circuit of claim 1, further comprising a dielectric cap layer on a top surface of the gate structure, wherein a top surface of the conductive structure is substantially coplanar with a top surface of the dielectric cap layer.

3. The integrated circuit of claim 1 or 2, wherein the conductive structure comprises a conductive liner directly on the dielectric fill and the dielectric layer, and a conductive fill on the conductive liner.

4. The integrated circuit of claim 3, wherein the conductive liner comprises titanium and nitrogen.

5. The integrated circuit of claim 3 or 4, wherein the conductive fill comprises any one of tungsten, ruthenium, molybdenum, or cobalt.

6. The integrated circuit of any one of claims 1 through 5, wherein the conductive structure is a first conductive structure, and the integrated circuit further comprises a second conductive structure on a top surface of the first conductive structure.

7. The integrated circuit of claim 6, wherein the integrated circuit further comprises a third conductive structure on a top surface of the second conductive structure, the third conductive structure having a greater width along the second direction than both of the first conductive structure and the second conductive structure.

8. The integrated circuit of any one of claims 1 through 7, wherein a width of the gate cut along the second direction is between about 25 nm and about 50 nm.

9. The integrated circuit of any one of claims 1 through 8, wherein the semiconductor region comprises a plurality of semiconductor nanoribbons.

10. The integrated circuit of claim 9, wherein the plurality of semiconductor nanoribbons comprise germanium, silicon, or a combination thereof.

11. The integrated circuit of any one of claims 1 through 10, wherein the conductive structure extends along the first direction until terminating at a dielectric structure that extends in the second direction across the gate cut.

12. The integrated circuit of claim 11, wherein the dielectric structure comprises a different dielectric material than the dielectric fill.

13. The integrated circuit of claim 11 or 12, wherein the dielectric structure comprises silicon and nitrogen and the dielectric fill comprises silicon and oxygen.

14. A printed circuit board comprising the integrated circuit of any one of claims 1 through 13.

15. A method of forming an integrated circuit, the method comprising:
forming one or more fins comprising semiconductor material, the one or more fins extending above a substrate and each extending parallel to one another in a first direction;
forming a gate electrode extending over the semiconductor material in a second direction different from the first direction;
forming a recess extending across the gate electrode in the first direction and extending in a third direction through an entire height of the gate electrode;
forming a dielectric layer within the recess;
forming a dielectric fill within a remaining volume of the recess and on the dielectric layer;
recessing a top surface of the dielectric fill to form a partial recess; and
forming a conductive structure on the top surface of the dielectric fill within the partial recess.
